# EUROPEAN PATENT APPLICATION

(11) **EP 1 746 724 A1**
(43) Date of publication of application: **24.01.2007**
(21) Application number: 05728414.3
(22) Date of filing: 05.04.2005
(51) Int. Cl.: H03K 5/00, H03K 5/15, H03L 7/081

(54) **EQUIPHASE POLYPHASE CLOCK SIGNAL GENERATOR CIRCUIT AND SERIAL DIGITAL DATA RECEIVER CIRCUIT USING THE SAME**

(30) Priority: 12.05.2004 JP 2004141770
(71) Applicant: Thine Electronics, Inc., Tokyo 103-0023 (JP)
(72) Inventor: OKAMURA, Jun-ichi, c/o THINE ELECTRONICS, INC., Tokyo 103-0023 (JP)
(74) Representative: Grünecker, Kinkeldey, Stockmair & Schwanhäusser Anwaltssozietät
(86) International application number: PCT/JP2005/006647
(87) International publication number: WO 2005/109642

(57) **Abstract**

(Problems) To realize a circuit capable of keeping a constant duty ratio of output isophase multiphase clock signals independently from the duty ratio of input clock signal while minimizing the increase of the number of devices and suppressing the increase of the circuit area of the semiconductor substrate and the increase of the power consumption.

(Means for Solving the Problems) In an isophase multiphase clock signal generation circuit according to the present invention, an input clock signal is converted into a 1/2-frequency-divided complementary clock signal and then is input to a complementary voltage controlled delay device array. The input clock signal is 1/2-frequency-divided, and therefore becomes a clock signal having a constant duty ratio with no dependency on the duty ratio of the input clock signal. The frequency-divided complementary clock signal is input to the voltage controlled delay device array, and the phase of the complementary output signal from the voltage controlled delay device array is compared with the phase of the frequency-divided complementary clock signal. Thus, isophase multiphase clock signals synchronized with the input clock signal can be output.

## Description

### TECHNICAL FIELD

The present invention relates to a serial digital data receiving circuit, and specifically to an isophase multiphase clock signal generation circuit using a DLL circuit, which is used in the serial digital data receiving circuit.

### BACKGROUND ART

Recently, for demodulating digital data in high speed serial digital data receiving circuits, the following system is generally used: Serial digital data is sampled using a symbol sampling signal of an isophase multiphase clock signal, which is synchronized with the cycle of a transmission clock signal. The cycle period of the transmission clock signal is N times the number of serialized symbol bits.

In a receiving circuit which adopts such a system of sampling serial digital data using isophase multiphase clock signals synchronized with a cycle of a transmission clock signal, a phase locked loop (PLL) circuit or a delay locked loop (DLL) circuit is generally used for generating isophase multiphase clock signals. The PLL circuit is a combination of a phase frequency detector and a voltage controlled oscillator. The DLL circuit is a combination of a phase detector and a voltage controlled delay device. A conventional DLL circuit generally used is described in, for example, Figure 24 of the following Patent Document 1.
Patent Document 1: Japanese Laid-Open Patent Publication No. 9-7396

In actual high speed serial digital transmission, a short-cycled frequency fluctuation called "jitter" is generated in transmission clock signals and serial transmission data due to the influence of, for example, a power supply fluctuation in a transmission circuit or external disturbance to the transmission line. In a high speed serial digital transmission signal receiving circuit, it is necessary that isophase multiphase clock signals used for sampling the received data should lock in the frequency fluctuation caused by jitter.

A receiving circuit using a delayed locked loop is excellent in the followability to the frequency fluctuation of transmission clock signals generated by jitter, and therefore is generally considered to be desirable as an isophase clock signal generation circuit used in a high speed serial digital transmission signal receiving circuit.

On the other hand, a high speed serial digital transmission signal receiving circuit, using such a delay locked loop circuit, adopts a circuit configuration for generating isophase multiphase clock signals synchronized with the cycle of an input clock signal by using the input clock signal itself and an output signal from the voltage controlled delay device to which the input clock signal has been input. In such a circuit configuration, the change in the duty ratio of the input clock signal itself is transferred through the voltage controlled delay device. Therefore, it is difficult to keep constant the duty ratio of the isophase multiphase clock signals, which are output signals, independently from the duty ratio of the input clock signal.

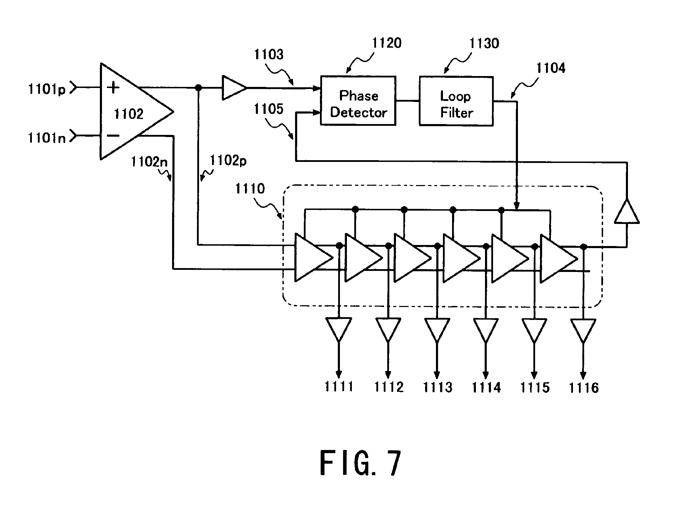

FIG. **7** shows a configuration of a conventional isophase multiphase clock signal generation circuit using a DLL circuit, which is usable in a serial digital transmission signal receiving circuit used for receiving serial transmission data.

In the isophase multiphase clock signal generation circuit using a DLL circuit in FIG. **7**, a complementary clock signal **1101p/1101n** input thereto and a complementary output signal **1102p/1102n** from a pre-amplification circuit **1102** are shown. The complementary output signal **1102p/1102n** is input to a complementary voltage controlled delay device array **1110**. An output signal **1105** therefrom and a signal **1103**, which is obtained by buffering one phase of the complementary output signal **1102p,** are compared with each other by a phase detector **1120** and shaped by a loop filter **1130**. The resultant signal **1104** is fed back as a controlled voltage signal for the complementary voltage controlled delay device array **1110.** With such a configuration, isophase multiphase clock signals 1111 through **1116** synchronized with the input clock signal can be generated and output. In the conventional example in FIG. **7,** six multiphase clock signals, having isophases which are each shifted by 360/6 (=60) degrees with respect to the cycle of the input clock signal, are output.

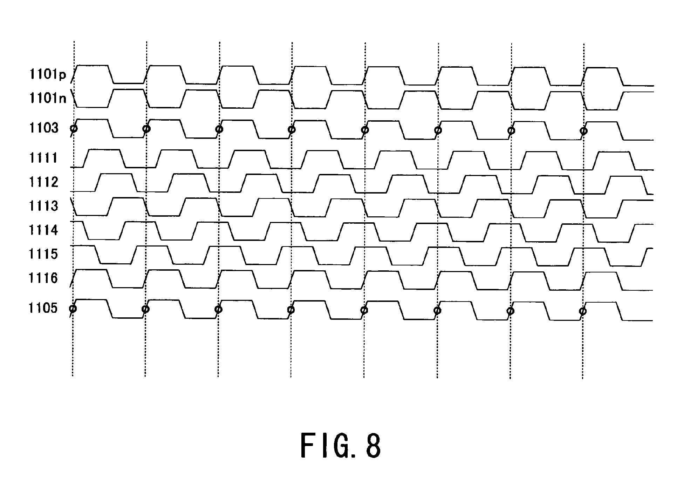

FIG. **8** is a timing diagram of internal signals in the conventional isophase multiphase clock signal generation circuit using the DLL circuit shown in FIG. **7.** The timing diagram shown in FIG. **8** is obtained when the internal signals are synchronized with the cycle of the complementary clock signal **1101p/1101n.**

FIG. **8** shows that the signal **1103** and the output signal **1105** from the complementary voltage controlled delay device array are synchronized with each other. Also from FIG. **8,** it is understood that isophase multiphase clock signals **1111** through **1116,** synchronized with the cycle of the input clock signal and having isophases which are each shifted by 360/6 (=60) degrees, are output.

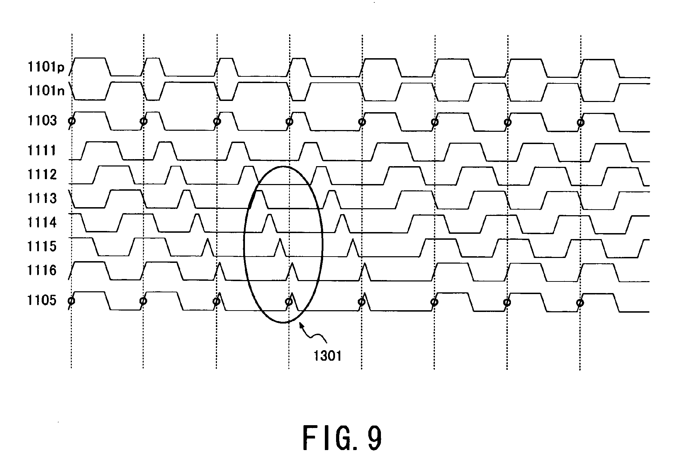

FIG. **9** is a timing diagram of internal signals obtained when an input clock signal **1101p/1101n** having a duty ratio significantly offset from 50% by the influence of jitter or the like is input to the conventional isophase multiphase clock signal generation circuit using the DLL circuit shown in FIG. **7.**

Because the duty ratio of the input clock signal **1101p/1101n** is significantly offset from 50%, the signal is deteriorated in shape while being propagated in the complementary voltage controlled delay device array **1110.** This enlarges the offset in the duty ratio of the input signal. As a result, as indicated by an ellipse **1301** in FIG. **9,** the duty ratio, which should be the same among the output isophase multiphase clock signals **1111** through **1116,** cannot be the same.

In order to solve this problem, it has been proposed to incorporate a 1/2 frequency division circuit for keeping the duty ratio of the input clock signal constant.

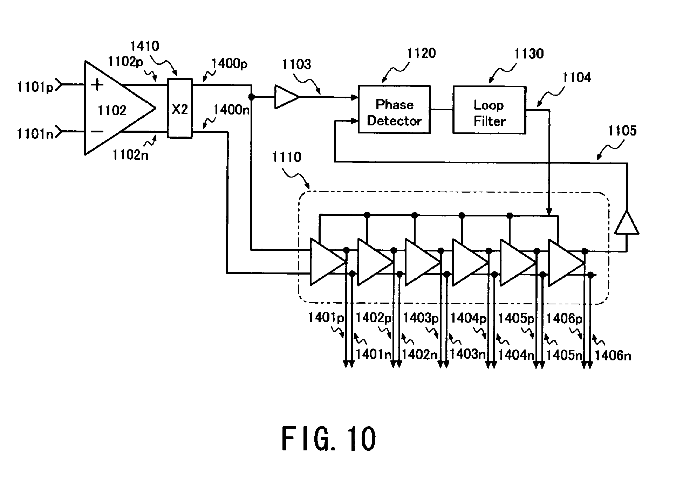

Here, FIG. **10** is referred to. FIG. **10** shows a conventional isophase multiphase clock signal generation circuit using a DLL circuit which incorporates a 1/2 frequency division circuit. The isophase multiphase clock signal generation circuit in FIG. **10** is usable in a serial digital transmission signal receiving circuit used for receiving serial transmission data.

A complementary clock signal **1101p/1101n** as an input signal and a complementary output signal **1102p/1102n** from a pre-amplification circuit **1102** are shown. The complementary clock signal **1102p/1102n** is converted by the 1/2 frequency division circuit **1410** into a complementary clock signal **1400p/1400n** having a constant duty ratio of 50% with no dependency on the duty ratio of the input signal **1101p/1101n.** According to the circuit configuration shown in FIG. **10,** the complementary clock signal **1400p/1400n** having a constant duty ratio of 50% is input to a complementary voltage controlled delay device array **1110.** An output signal **1105** from the complementary voltage controlled delay device array **1110** and a signal **1103,** which is obtained by buffering the complementary output signal **1400p/1400n,** are compared with each other by a phase detector **1120** and shaped by a loop filter **1130.** The resultant output signal **1104** is fed back as a controlled voltage signal for the complementary voltage controlled delay device array **1110.** In such an isophase multiphase clock signal generation circuit, complementary isophase multiphase clock signals **1401p/1401n** through **1406p/1406n,** synchronized with the input signal and having isophases each shifted by 2 × 360/6 (=120) degrees to the cycle of the input clock signal, are output.

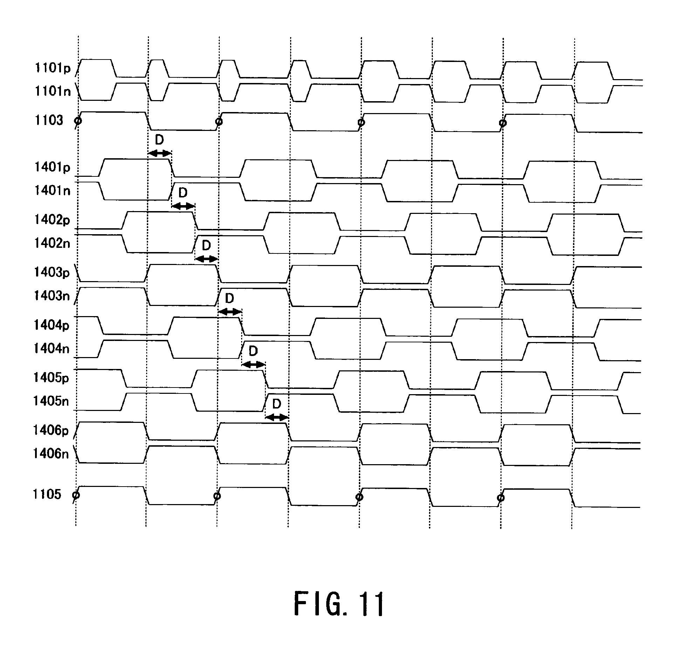

FIG. **11** is a timing diagram of internal signals in the conventional isophase multiphase clock signal generation circuit using the DLL circuit shown in FIG. **10.** The timing diagram shown in FIG. **11** is obtained when the internal signals are synchronized with the cycle of the input clock signal. From FIG. **11,** it is understood that the signal **1103,** obtained by buffering the complementary clock signal **1400p/1400n,** and the output signal **1105** from the complementary voltage controlled delay device array **1110** are synchronized with each other. Also from FIG. **11,** it is understood that isophase multiphase clock signals **1401p/1401n** through **1406p/1406n,** synchronized with the input signal and having isophases each shifted by 2 × 360/6 (=120) degrees to the cycle of the input clock signal, are output.

### DISCLOSURE OF THE INVENTION

### PROBLEMS TO BE SOLVED BY THE INVENTION

As described above with reference to FIGs. **10** and **11,** when a 1/N frequency division clock signal is applied to an input of an isophase multiphase clock generation circuit using a DLL circuit, isophase M multiphase clock signals, having a duty ratio independent from the duty ratio of the input clock signal and a phase difference of N × 360/M, can be generated as output clock signals.

However, when the frequency of the input clock signal is divided by N, M × N phase clock signals need to be generated in order to output signals having the same phase difference as that in the case where the frequency of the input clock signal is not divided. This requires N times the number of complementary voltage controlled delay devices in the DLL circuit, which unavoidably enlarges the circuit scale. Such circuit, requires large area on the semiconductor substrate and consumes large electrical power.

### MEANS FOR SOLVING THE PROBLEMS

In view of the foregoing, the present invention has an object of realizing a circuit capable of keeping a constant duty ratio of output isophase multiphase clock signals independently from the duty ratio of an input clock signal while minimizing the increase of the number of devices and suppressing the increase of the circuit area of the semiconductor substrate and the increase of the power consumption.

The isophase multiphase clock signal generation circuit using a DLL circuit according to the present invention, converts an input clock signal into a 1/2-frequency-divided complementary clock signal, and input the 1/2-frequency-divided complementary clock signal to a complementary voltage controlled delay device array. The input complementary clock signal is 1/2-frequency-divided, and becomes a clock signal having a constant duty ratio (e.g., 50%) with no dependency on the duty ratio of the input clock signal. In this frequency division circuit, the positive phase signals or the inverted phase signals of the frequency-divided complementary clock signal are sequentially synchronized at a timing of one cycle of the input complementary clock signal. In other words, this frequency division circuit sequentially synchronizes the rise edges (or the fall edges) of the input complementary clock signal with rise edges (or the fall edges) of the positive phase signals or rise edges (or the fall edges) of inverted phase signals of the second complementary clock signal.

The frequency-divided complementary clock signal is input to the voltage controlled delay device array (the voltage controlled delay circuit), and the phase of the complementary output signal from the voltage controlled delay device array is compared with the phase of the frequency-divided complementary clock signal. Thus, the isophase multiphase clock signals synchronized with the input clock signal can be output.

In the isophase multiphase clock signal generation circuit according to the present invention, the duty ratio of the complementary clock signal which is input to the complementary voltage controlled delay device array is fixed to a constant value regardless of the duty ratio of the input clock signal. Therefore, the duty ratio of the multiphase clock signal which is output from the complementary voltage controlled delay device array is also kept constant. For example, when the duty ratio of the complementary clock signal which is input to the complementary voltage controlled delay device array is kept at 50%, the duty ratio of the multiphase clock signal which is output from the complementary voltage controlled delay device array is also kept at 50%.

The isophase multiphase clock signal generation circuit according to the present invention, switch the edge (the rise edge or the fall edge) of the frequency-divided complementary clock signal to be phase-compared in time with the complementary clock signal. In other words, the positive phase signals and the inverted phase signals of the frequency-divided complementary clock signal are sequentially synchronized with the complementary output signal from the complementary voltage controlled delay circuit. Namely, the positive phase signals of the frequency-divided complementary clock signal and the inverted phase signals of the complementary output signal from the complementary voltage controlled delay circuit are synchronized with each other, and the inverted phase signals of the frequency-divided complementary clock signal and the positive phase signals of the complementary output signal from the complementary voltage controlled delay circuit are synchronized with each other.

In other words, the isophase multiphase clock signal generation circuit does not operate to synchronize the output signal from the complementary voltage controlled delay device array with the complementary clock signal which has been frequency-divided to twice period, which is out of phase with the output signal by the phase (360 degrees) corresponding to twice the cycle period of the input clock signal which is input to the circuit. The isophase multiphase clock signal generation circuit operate to synchronize the output signal from the complementary voltage controlled delay device array with the signal which is out of phase with the output signal by the phase (180 degrees) corresponding to the cycle period of the input clock signal which is input to the circuit.

As a result, the clock signal output from the voltage controlled delay device array is synchronized with the cycle which the proper input clock signal. Owing to this, the total number of voltage controlled delay device arrays required for obtaining an array of multiphase output clock signals at an isophase interval can be reduced, the circuit scale can be reduced, the circuit area of the semiconductor substrate can be reduced, the power consumption can be reduced, and the operation noise can be significantly reduced.

As described above, in the isophase multiphase clock signal generation circuit according to the present invention, the cycle period of the multiphase output clock signal array from the voltage controlled delay device array is twice the cycle period which the proper input clock signal. However, since the duty ratio of the multiphase output clock signals is fixed, multiphase output clock signals synchronized with the cycle of the input clock signal can be easily realized by providing a doubler circuit for making the cycle period half.

In the case of the conventional isophase multiphase clock signal generation circuit described above, normal operation is only guaranteed when the duty ratio of the input clock signal is within the range of 30% to 70%. By contrast, the isophase multiphase clock signal generation circuit according to the present invention is operable in a wide duty ratio range of the input signal of 10% to 90%, and realizes high reliability against the frequency fluctuation of the input clock signal caused by the influence of jitter or the like.

According to the present invention, an isophase multiphase clock signal generation circuit is provided. The isophase multiphase clock signal generation circuit comprises a frequency division circuit for 1/2-frequency-dividing an input first complementary clock signal to generate a second complementary clock signal having a constant duty ratio, the frequency division circuit including control means for sequentially synchronizing positive phase signals or inverted phase signals of the second complementary clock signal; a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices; a double phase detector for comparing the phase of the complementary output signal from the complementary voltage controlled delay circuit with the phase of the second complementary clock signal; and a loop filter for shaping the output signal from the double phase detector and outputting the resultant signal as a controlled voltage signal to the plurality of voltage controlled delay devices of the complementary voltage controlled delay circuit.

Also according to the present invention, an isophase multiphase clock signal generation circuit is provided. The isophase multiphase clock signal generation circuit comprises
a frequency division circuit for 1/2-frequency-dividing an input first complementary clock signal to generate a second complementary clock signal having a constant duty ratio, the frequency division circuit including control means for sequentially synchronizing rise edges of the first complementary clock signal with rise edges of positive phase signals or rise edges of inverted phase signals of the second complementary clock signal;
a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices,
and generates a complementary output signal in the final-stage device of the plurality of voltage controlled delay devices; a double phase detector for comparing the phase of the complementary output signal from the complementary voltage controlled delay circuit with the phase of the second complementary clock signal; and a loop filter for shaping the output signal from the double phase detector and outputting the resultant signal as a controlled voltage signal to the plurality of voltage controlled delay devices of the complementary voltage controlled delay circuit.

In the double phase detector, the positive phase signal or the inverted phase signals signal of the second complementary clock signal may be sequentially synchronized with the complementary output signal from the complementary voltage controlled delay circuit.

In the double phase detector, the positive phase signals of the second complementary clock signal may be synchronized with the inverted phase signals of the complementary output signal from the complementary voltage controlled delay circuit, and the inverted phase signals of the second complementary clock signal may be synchronized with the positive phase signals of the complementary output signal from the complementary voltage controlled delay circuit.

In the double phase detector, rise edges of the positive phase signals of the second complementary clock signal may be synchronized with rise edges of the inverted phase signals of the complementary output signal from the complementary voltage controlled delay circuit, and rise edges of the inverted phase signals of the second complementary clock signal may be synchronized with rise edges of the positive phase signals of the complementary output signal from the complementary voltage controlled delay circuit.

A duty ratio of the first complementary clock signal is within the range of 10% to 90%.

The isophase multiphase clock signal generation circuit may further comprise a doubler circuit for converting a cycle period of the isophase multiphase clock signals.

According to the present invention, a serial digital data receiving circuit is provided. The serial digital data receiving circuit comprises an isophase multiphase clock signal generation circuit including a frequency division circuit for 1/2-frequency-dividing an input first complementary clock signal to generate a second complementary clock signal having a constant duty ratio, the frequency division circuit including control means for sequentially synchronizing positive phase signals or inverted phase signals of the second complementary clock signal; a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices; a double phase detector for comparing the phase of the complementary output signal from the complementary voltage controlled delay circuit with the phase of the second complementary clock signal; and a loop filter for shaping the output signal from the double phase detector and outputting the resultant signal as a controlled voltage signal to the plurality of voltage controlled delay devices of the complementary voltage controlled delay circuit; and a de-serializer for de-serializing input serial digital data based on the isophase multiphase clock signals.

According to the present invention, a serial digital data receiving circuit is provided. The serial digital data receiving circuit comprises an isophase multiphase clock signal generation circuit including a frequency division circuit for 1/2-frequency-dividing an input first complementary clock signal to generate a second complementary clock signal having a constant duty ratio, the frequency division circuit including control means for sequentially synchronizing rise edges of the first complementary clock signal with rise edges of positive phase signals or rise edges of inverted phase signals of the second complementary clock signal; a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices; a double phase detector for comparing the phase of the complementary output signal from the complementary voltage controlled delay circuit with the phase of the second complementary clock signal; and a loop filter for shaping the output signal from the double phase detector and outputting the resultant signal as a controlled voltage signal to the plurality of voltage controlled delay devices of the complementary voltage controlled delay circuit; and a de-serializer for de-serializing input serial digital data based on the isophase multiphase clock signals.

In the double phase detector, the positive phase signals or the inverted phase signals of the second complementary clock signal may be sequentially synchronized with the complementary output signal from the complementary voltage controlled delay circuit.

In the double phase detector, the positive phase signals of the second complementary clock signal may be synchronized with the inverted phase signals of the complementary output signal from the complementary voltage controlled delay circuit, and the inverted phase signals of the second complementary clock signal may be synchronized with the positives phase of the complementary output signal from the complementary voltage controlled delay circuit.

In the double phase detector, rise edges of the positive phase signals of the second complementary clock signal may be synchronized with rise edges of the inverted phase signals of the complementary output signal from the complementary voltage controlled delay circuit, and rise edges of the inverted phase signals of the second complementary clock signal may be synchronized with rise edges of the positive phase signals of the complementary output signal from the complementary voltage controlled delay circuit.

A duty ratio of the first complementary clock signal is within the range of 10% to 90%.

The serial digital data receiving circuit may further comprise a doubler circuit for converting a cycle period of the isophase multiphase clock signals.

### EFFECT OF THE INVENTION

As described above, in an isophase multiphase clock signal generation circuit according to the present invention, the clock signal output from the voltage controlled delay device array is synchronized at the cycle which the proper input clock should have. Owing to this, the output isophase multiphase output clock signals can keep a constant duty ratio independently from the duty ratio of the input clock signal and follow the frequency fluctuation of the input clock signal, while the total number of voltage controlled delay device arrays required for obtaining an array of multiphase output clock signals at an isophase interval can be reduced. This provides superb effects of reducing the circuit scale, reducing the circuit area of the semiconductor substrate, reducing the power consumption, and significantly reducing the operation noise.

In the case of the conventional isophase multiphase clock signal generation circuit described above, normal operation is only guaranteed when the duty ratio of the input clock signal is within the range of 30% to 70%. By contrast, the isophase multiphase clock signal generation circuit according to the present invention is operable in a wide duty ratio range of the input signal of 10% to 90%, and realizes high reliability against the frequency fluctuation of the input clock signal caused by the influence of jitter or the like.

Therefore, the present invention can solve the problem of the frequency fluctuation in the transmission clock signal caused by jitter in actual high speed serial digital transmission, and realize a superb serial digital transmission signal receiving circuit.

### BRIEF DESCRIPTION OF THE DRAWINGS

FIG. **1** shows an isophase multiphase clock signal generation circuit according to one embodiment of the present invention.
FIG. **2** is a timing diagram of internal signals in the isophase multiphase clock signal generation circuit according to the present invention shown in FIG. **1,** obtained when the internal signals are synchronized with an input clock signal **101p/101n.**
FIG. **3** shows an example of a 1/2 frequency division circuit.
FIG. **4** shows an example of a doubler circuit.
FIG. **5** is a timing diagram of internal signals in the isophase multiphase clock signal generation circuit according to the present invention shown in FIG. **1,** obtained when the internal signals are synchronized with a complementary clock signal **103p/103n.**
FIG. **6** shows an example of a serial digital data receiving circuit using an isophase multiphase clock signal generation circuit according to the present invention.
FIG. **7** shows a conventional isophase multiphase clock signal generation circuit.
FIG. **8** is a timing diagram of internal signals in the conventional isophase multiphase clock signal generation circuit shown in FIG. **7,** obtained when the internal signals are synchronized with the cycle of a complementary clock signal **1101p/1101n.**
FIG. **9** is a timing diagram obtained when an input clock signal **1101p/1101n** having a duty ratio significantly offset from 50% is input to the conventional isophase multiphase clock signal generation circuit using a DLL circuit shown in FIG. **7.**
FIG. **10** shows a conventional isophase multiphase clock signal generation circuit.
FIG. **11** is a timing diagram of internal signals in the conventional isophase multiphase clock signal generation circuit shown in FIG. **10,** obtained when the internal signals are synchronized with the cycle of a complementary clock signal **1101p/1101n.**

### DESCRIPTION OF THE REFERENCE NUMERALS

- **100**: Isophase multiphase clock signal generation circuit
- **102**: Pre-amplification circuit
- **110**: Complementary voltage controlled delay device array
- **130**: Loop filter circuit
- **410**: 1/2 frequency division circuit
- **411, 412, 413, 414**: Buffer
- **420**: Double phase detector
- **430**: Doubler circuit
- **101p/101n**: Complementary clock signal
- **111 - 116**: Isophase multiphase clock signal

### BEST MODE FOR CARRYING OUT THE INVENTION

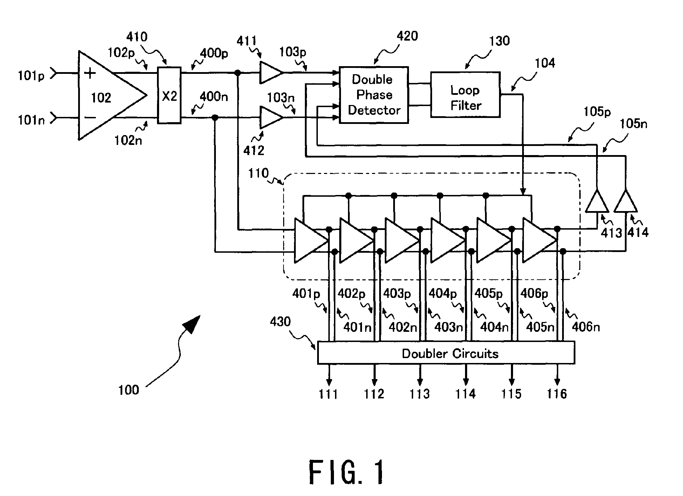

Embodiments of an isophase multiphase clock signal generation circuit according to the present invention will be described with reference to FIGs. **1** through **5.**

FIG. **1** shows a circuit configuration of an isophase multiphase clock signal generation circuit **100** according to one embodiment of the present invention. The isophase multiphase clock signal generation circuit **100** according to the present invention receives a complementary clock signal **101p/101n** input thereto. By the isophase multiphase clock signal generation circuit **100,** isophase multiphase clock signals **111** through **116** are generated and output.

The isophase multiphase clock signal generation circuit **100** includes a pre-amplification circuit **102,** a 1/2 frequency division circuit **410,** buffers **411, 412, 413** and **414,** a double phase detector **420,** a loop filter **130,** a complementary voltage controlled delay device array **110** including six complementary voltage controlled delay devices, and a doubler circuit **430.** The pre-amplification circuit **102,** the buffers **411, 412, 413** and **414,** and the doubler circuit **430** may be provided when necessary.

First, the complementary clock signal **101p/101n** is input to the pre-amplification circuit **102** of the isophase multiphase clock signal generation circuit **100.** The complementary clock signal **101p/101n** is amplified to a complementary output clock signal **102p/102n** by the pre-amplification circuit **102.** The complementary output clock signal **102p/102n** is input to the 1/2 frequency division circuit **410** and converted into a 1/2-frequency-divided complementary clock signal **400p/400n** having a constant duty ratio of 50% with no dependency on the duty ratio of the complementary clock signal **101p/101n.**

In this embodiment, the 1/2-frequency-divided complementary clock signal **400p/400n** having a constant duty ratio of 50% is generated by the 1/2 frequency division circuit **410.** The present invention is not limited to this, and a 1/2-frequency-divided complementary clock signal **400p/400n** having any constant duty ratio may be generated (including a duty ratio slightly offset from a predetermined duty ratio due to the circuit configuration of the frequency division circuit **410,** noise of the like).

The 1/2-frequency-divided complementary clock signal **400p/400n** having a constant duty ratio of 50% is input to the complementary voltage controlled delay device array **110.** More specifically, the 1/2-frequency-divided complementary clock signal **400p/400n** is input to six complementary voltage controlled delay devices connected in series in the complementary voltage controlled **delay device array 110.** The complementary clock signal **400p/400n** is propagated while being phase-delayed by each of the complementary voltage controlled delay devices.

An output signal from the complementary voltage controlled delay device array **110** (in this embodiment, an output signal from the final-stage device among the six complementary voltage controlled delay devices connected in series) is buffered by the buffers **413** and **414** to provide an output signal **105p/105n.** The complementary clock signal 400p/400n is buffered by the buffers **411** and **412** to provide a complementary clock signal **103p/103n.** The output signal **105p/105n** and the complementary clock signal **103p/103n** are compared with each other by the double phase detector **420.** An output signal from the double phase detector **420** is shaped by the loop filter circuit **130** to provide an output signal **104,** which is input to the complementary voltage controlled delay device array **110.** The output signal **104** is fed back as a controlled voltage signal for the complementary voltage controlled delay device array **110.**

In the isophase multiphase clock signal generation circuit **100,** the cycle period of the complementary clock signal **400p/400n** which is input to the complementary voltage controlled delay device array **110** is twice the cycle period of the input clock signal **101p/101n** which is externally input to the isophase multiphase clock signal generation circuit **100.** Therefore, the cycle period of the isophase multiphase clock signals **401p/401n, 402p/402n, 403p/403n, 404p/404n, 405p/405n** and **406p/406n** from the complementary voltage controlled delay device array **110** is twice the cycle period of the input clock signal **101p/101n.** According to the circuit configuration of this embodiment, the isophase multiphase clock signals **401p/401n, 402p/402n, 403p/403n, 404p/404n, 405p/405n** and 406p/406n are passed through the doubler circuit 430 to make the cycle period to half, so that the isophase multiphase clock signals **111** through **116** synchronized with the cycle of the input clock signal **101p/101n** are output.

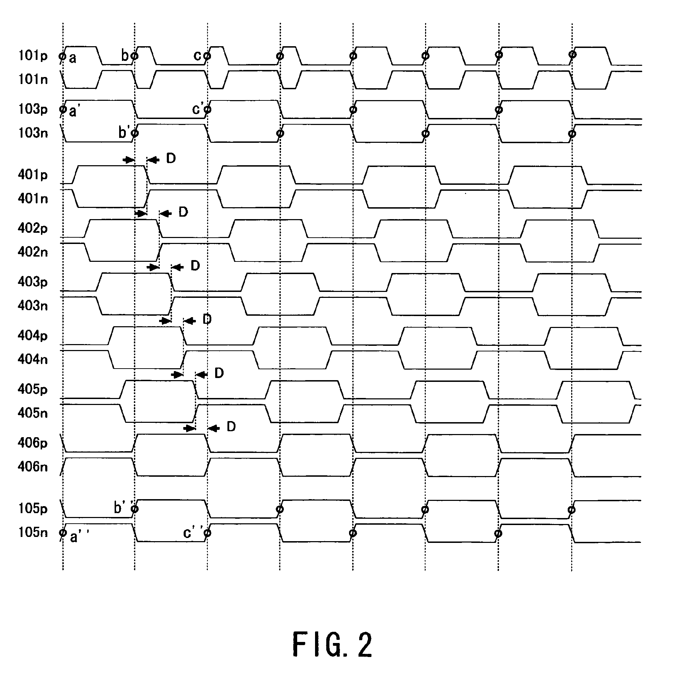

FIG. **2** is a timing diagram of internal signals in the isophase multiphase clock signal generation circuit according to the present invention shown in FIG. **1.** The timing diagram shown in FIG. **2** is obtained when the internal signals are synchronized with the input clock signal **101p/101n.** As shown in FIG. **2,** even when the input clock signal **101p/101n** having a duty ratio significantly offset from 50% is input, the complementary clock signal **103p/103n** obtained by passing the input clock signal **101p/101n** through the 1/2 frequency division circuit **410** has a constant duty ratio of 50%. In the frequency division circuit **410,** the positive phase signal **103p or** the inverted phase signal **103n** of the frequency-divided complementary clock signal are sequentially synchronized at the timing of one cycle period of the input complementary clock signal **101p/101n.** In other words, in this frequency division circuit, the rise edges of the input complementary clock signal **101p/101n** are sequentially synchronized with the rise edges of the positive phase signal **103p** or the rise edges of the inverted phase signal **103n** of the complementary clock signal. This will be described more specifically with reference to FIG. **2**. In the frequency division circuit **410,** point **a** of the input complementary clock signal **101p/101n** is synchronized with point **a'** of the positive phase **103p** of the frequency-divided complementary clock signal. Point **b** of the input complementary clock signal **101p/101n** is synchronized with point **b'** of the inverted phase signal **103n** of the frequency-divided complementary clock signal. Point **c** of the input complementary clock signal **101p/101n** is synchronized with point **c'** of the positive phase **103p** of the frequency-divided complementary clock signal.

The edge (the rise edge in this embodiment) of the complementary clock signal **103p/103n** to be phase-compared by the double phase detector **420** is switched between the edge of the positive phase **(103p)** and the edge of the inverted phase **(103n)** of the complementary clock signal **103p/103n.** As a result, the output signal **105p/105n** from the complementary voltage controlled delay device array **110** and the complementary clock signal **103p/103n** are synchronized with each other at a timing of half the cycle period of the complementary clock signal **103p/103n.**

In this embodiment, as shown in FIG. **2,** the positive phase **103p** of the complementary clock signal and the inverted phase **105n** of the output signal from the complementary voltage controlled delay device array **110** (point **a'** of **103p** and point **a"** of **105n)** are synchronized with each other. Also, the inverted phase **103n** of the complementary clock signal and the positive phase **105p** of the output signal from the complementary voltage controlled delay device array **110** (point **b'** of **103n** and point **b"** of **105p)** are synchronized with each other. In other words, the positive phase signal **(103p)** and the inverted phase signal **(103n)** of the frequency-divided complementary clock signal **103p/103n** are sequentially synchronized with the complementary output signal **105p/105n** from the complementary voltage controlled delay device array **110.** In still other words, the synchronization regarding the complementary clock signal **103p/103n,** which has been frequency-divided to have twice the cycle period, is not performed between the complementary clock signal **103p/103n** and the output signal **105p/105n** from the complementary voltage controlled delay device array **110,** which are separated from each other by a phase corresponding to twice the cycle period of the input clock signal **101p/101n** input to the circuit (by 360 degrees). The synchronization is performed between the complementary clock signal **103p/103n** and the output signal **105p/105n** from the complementary voltage controlled delay device array **110,** which are separated from each other by a phase corresponding to the cycle period of the input clock signal **101p/101n** input to the circuit (by 180 degrees).

As a result, in FIG. **2,** point **a'** and point **a"** are synchronized with each other, point **b'** and point **b"** are synchronized with each other, and point **c'** and point **c"** are synchronized with each other.

Owing to the above-described configuration, the complementary delay signals **401p/401n, 402p/402n, 403p/403n, 404p/404n, 405p/405n** and **406p/406n** from the complementary voltage controlled delay device array **110** are output as signals having a phase difference (D) of 180/6 (=30) degrees with respect to the complementary clock signal **103p/103n.** Since the cycle period of the complementary clock signal **103p/103n** is twice the cycle period of the input complementary clock signal **101p/101n,** the phase difference (D) corresponds to a phase difference of 360/6 (=60) degrees for the input complementary clock signal **101p/101n.**

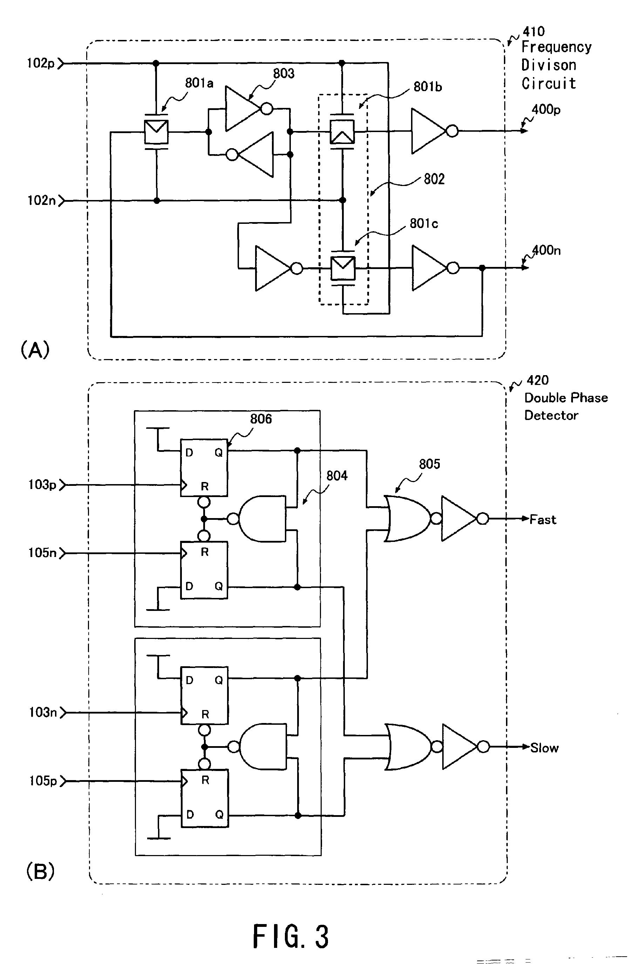

Next, FIG. **3** will be referred to. FIG. **3** shows an example of the 1/2 frequency division circuit **410** (FIG. **3(A))** and the double phase detector **420** (FIG. **3(B)**) which are used for the isophase multiphase clock signal generation circuit in this embodiment shown in FIG. **1.**

The frequency division circuit **410** converts the complementary output clock signal **102p/102n** into the complementary clock signal **400p/400n** having twice the cycle period. The frequency division circuit **410** shown in FIG. **3(A)** includes three CMOS transfer gate circuits **801a** through **801c** and five CMOS inverter circuits **803.** The frequency division circuit **410** shown in FIG. **3(A)** is merely an example, and any circuit having equivalent functions thereto is usable as the frequency division circuit **410** of the isophase multiphase clock signal generation circuit **100** according to the present invention.

In the frequency division circuit **410** shown in FIG. **3,** the complementary output clock signal **102p/102n** input thereto is input to the three CMOS transfer gate circuits **801a** through **801c.** Control means **802** including the CMOS transfer gate circuits **801b** and **801c** has a function of matching the timing of points **a, b** and **c** of the input complementary clock signal **101p/101n** shown in FIG. **2** respectively to the timing of points **a', b'** and **c'** of the inverted complementary clock signal **103p/103n** obtained by inverting the complementary clock signal **400p/400n** from the frequency division circuit **410.** Namely, the control means 802 synchronizes points **a, b** and **c** to points **a', b'** and **c',** respectively.

The use of the frequency division circuit **410** provides the following effect. Even when the input complementary clock signal **101p/101n** having a duty ratio significantly offset from 50% is input, the complementary clock signal **400p/400n (103p/103n)** obtained by passing the input clock signal **101p/101n** through the 1/2 frequency division circuit **410** keeps 50% duty ratio.

As shown in FIG. **3(B),** the double phase detector **420** in this embodiment includes two CMOS NAND circuits **804,** two CMOS NOR circuits **805,** and four D-type flip-flop circuits **806.** The double phase detector **420** compares the phase of the positive phase **103p** of the complementary clock signal with the phase of the inverted phase **105n** of the output signal from the complementary voltage controlled delay device array **110.** The double phase detector **420** also compares the phase of the inverted phase **103n** of the complementary clock signal with the phase of the positive phase **105p** of the output signal from the complementary voltage controlled delay device array **110.** Thus, the double phase detector **420** operates and outputs the phase difference of each signal. The double phase detector **420** shown in FIG. **3(B)** is merely an example, and any circuit having equivalent functions thereto is usable as the double phase detector **420** of the isophase multiphase clock signal generation circuit **100** according to the present invention.

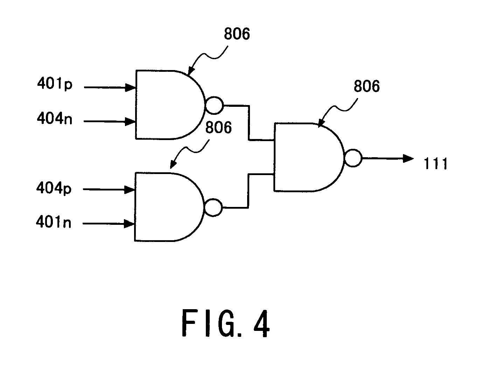

Next, FIG. **4** will be referred to. FIG. **4** shows an example of the doubler circuit **430** used in the isophase multiphase clock signal generation circuit in this embodiment shown in FIG. **1.** As shown in FIG. **4,** in this embodiment, the doubler circuit **430** includes three CMOS NAND circuits **807.** The doubler circuit **430** shown in FIG. **4** is merely an example, and any circuit having equivalent functions thereto is usable as the doubler circuit **430** of the isophase multiphase clock signal generation circuit **100** according to the present invention.

In the isophase multiphase clock signal generation circuit according to the present invention, the complementary delay signals **401p/401n, 402p/402n, 403p/403n, 404p/404n, 405p/405n** and **406p/406n** from the complementary voltage controlled delay device array 110 keeps 50% duty ratio. Therefore, a combination of logic circuits is usable as the doubler circuit **430** as shown in FIG. **4.**

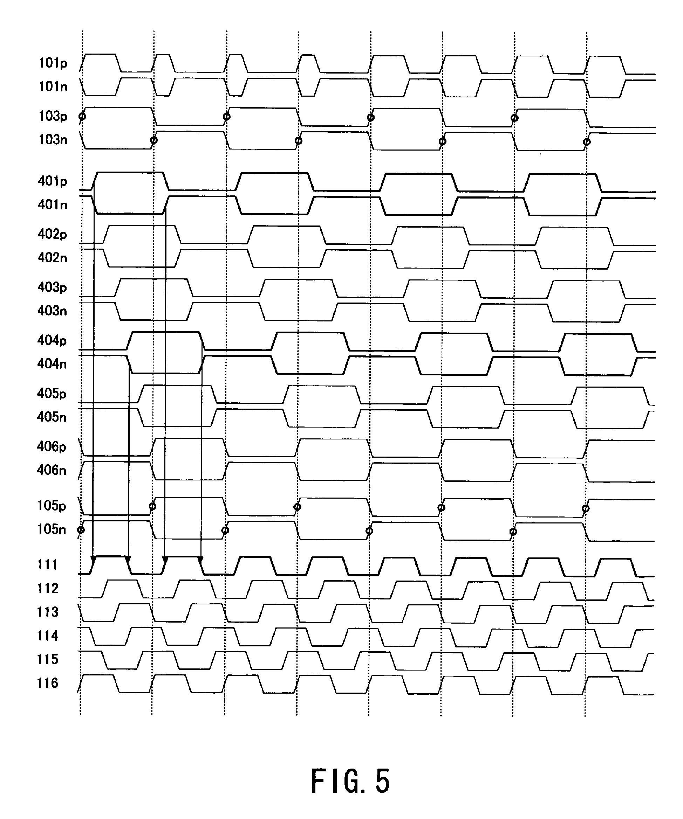

FIG. **5** is a timing diagram of internal signals in the isophase multiphase clock signal generation circuit in this embodiment shown in FIG. **1.** The timing diagram shown in FIG. **5** is obtained when the internal signals are synchronized with the complementary clock signal **103p/103n.** The complementary delay signals **401p/401n, 402p/402n, 403p/403n, 404p/404n, 405p/405n** and **406p/406n** from the complementary voltage controlled delay device array **110** are output as signals having a phase difference of 180/6 (=30) degrees with respect to the complementary clock signal **103p/103n.** FIG. **5** shows that these signals are input to the doubler circuit **430** to make the cycle period thereof half, and as a result, the isophase multiphase clock signals **111** through **116** synchronized with the cycle of the input complementary clock signal **101p/101n** are output.

As described above, according to the isophase multiphase clock signal generation circuit in this embodiment, the clock signal output from the voltage controlled delay device array is synchronized at the cycle which the proper input clock signal should have. Owing to this, the output isophase multiphase output clock signals can keep a constant duty ratio independently from the duty ratio of the input clock signal and follow the frequency fluctuation of the input clock signal, while the total number of voltage controlled delay device arrays required for obtaining an array of multiphase output clock signals at an isophase interval can be reduced. This provides superb effects of reducing the circuit scale, reducing the circuit area of the semiconductor substrate, reducing the power consumption, and significantly reducing the operation noise.

In the case of the conventional isophase multiphase clock signal generation circuit described above, normal operation is only guaranteed when the duty ratio of the input clock signal is within the range of 30% to 70%. By contrast, the isophase multiphase clock signal generation circuit according to the present invention is operable in a wide duty ratio range of the input signal of 10% to 90%, and realizes high reliability against the frequency fluctuation of the input clock signal caused by the influence of jitter or the like.

### EXAMPLE 1

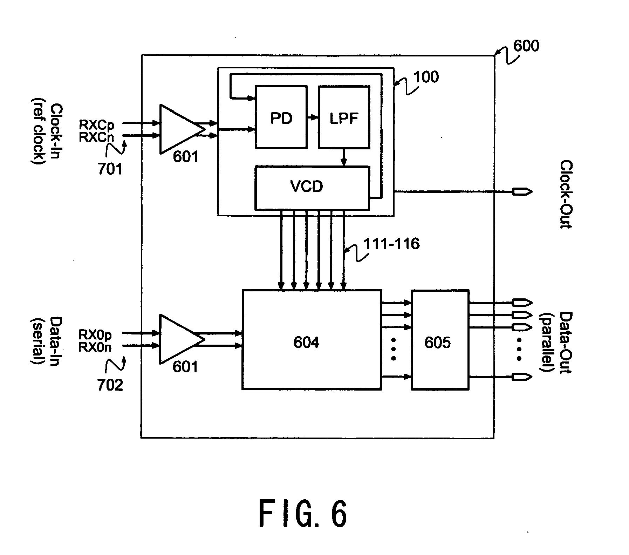

In this example, a serial digital data receiving circuit including an isophase multiphase clock signal generation circuit according to the present invention will be described with reference to FIG. **6.**

Reference **600** represents a serial digital data receiving circuit, which includes two buffers **601,** a de-serializer **604,** a multiplexer circuit **605,** and an isophase multiphase clock signal generation circuit **100.** To the serial digital data receiving circuit **600,** a reference clock **701** and serial digital data **702** are input externally.

As the isophase multiphase clock signal generation circuit **100,** the circuit described in the above embodiment is usable. In FIG. **6,** the double phase detector is labeled as **"PD",** the loop filter is labeled as **"LPF",** and the complementary voltage controlled delay device array is labeled as **"VCD".**

In the serial digital data receiving circuit **600,** the serial digital data **702** externally input is amplified by the buffer **601** and then is input to the de-serializer **604.** The reference clock **701** is also amplified by the buffer **601** and then is output to the isophase multiphase clock signal generation circuit **100.**

The isophase multiphase clock signal generation circuit **100** generates isophase multiphase clock signals **111** through **116** based on the complementary clock signal which has been output from the buffer **601** and input to the circuit **100,** and outputs the generated isophase multiphase clock signals **111** through **116** to the de-serializer **604** and then to an external device.

The de-serializer **604** de-serializes the serial digital data **702** input thereto based on the isophase multiphase clock signals **111** through **116** to generate parallel data, and outputs the generated parallel data to the multiplexer circuit **605.** The multiplexer circuit **605** selects the input parallel data in accordance with the timing and externally outputs the selected data.

The serial digital data receiving circuit in this example uses the isophase multiphase clock signal generation circuit described in the above embodiment. In the isophase multiphase clock signal generation circuit, the clock signal output from the voltage controlled delay device array is synchronized at the cycle which the proper input clock signal should have. Owing to this, the output isophase multiphase clock signals can keep a constant duty ratio independently from the duty ratio of the input clock signal and follow the frequency fluctuation of the input clock signal, while the total number of voltage controlled delay device arrays required for obtaining an array of multiphase output clock signals at an isophase interval can be reduced. This provides superb effects of reducing the serial digital data receiving circuit as in this example, reducing the circuit area of the semiconductor substrate, reducing the power consumption, and significantly reducing the operation noise.

In the case of a serial digital data receiving circuit using the above-described conventional isophase multiphase clock signal generation circuit, normal operation is only guaranteed when the duty ratio of the input clock signal is within the range of 30% to 70%. By contrast, the isophase multiphase clock signal generation circuit used in this example is operable in a wide duty ratio range of the input signal of 10% to 90%, and realizes high reliability against the frequency fluctuation of the input clock signal caused by the influence of jitter or the like.

### INDUSTRIAL APPLICABILITY

As described above, an isophase multiphase clock signal generation circuit according to the present invention can keep constant the duty ratio of output isophase multiphase clock signals independently from the duty ratio of input clock signal and allow the output isophase multiphase clock signals to follow the frequency fluctuation of the input clock signal, while reducing the total number of voltage controlled delay device arrays required for obtaining an array of multiphase output clock signals at an isophase interval. This provides superb effects of reducing the serial digital data receiving circuit, reducing the circuit area of the semiconductor substrate, reducing the power consumption, and significantly reducing the operation noise as in this embodiment.

Therefore, the isophase multiphase clock signal generation circuit according to the present invention is usable in a serial digital data receiving circuit in a serial digital transmission system, and also is usable in any type of electronic circuits which require an isophase multiphase clock signal.

## Claims

1. An isophase multiphase clock signal generation circuit, comprising:
a frequency division circuit for 1/2-frequency-dividing an input first complementary clock signal to generate a second complementary clock signal having a constant duty ratio, the frequency division circuit including control means for sequentially synchronizing positive phase signals or inverted phase signals of the second complementary clock signal;
a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices;
a double phase detector for comparing the phase of the complementary output signal from the complementary voltage controlled delay circuit with the phase of the second complementary clock signal; and
a loop filter for shaping the output signal from the double phase detector and outputting the resultant signal as a controlled voltage signal to the plurality of voltage controlled delay devices of the complementary voltage controlled delay circuit.

2. An isophase multiphase clock signal generation circuit, comprising:
a frequency division circuit for 1/2-frequency-dividing an input first complementary clock signal to generate a second complementary clock signal having a constant duty ratio, the frequency division circuit including control means for sequentially synchronizing rise edges of the first complementary clock signal with rise edges of positive phase signals or rise edges of inverted phase signals of the second complementary clock signal;
a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices;
a double phase detector for comparing the phase of the complementary output signal from the complementary voltage controlled delay circuit with the phase of the second complementary clock signal; and
a loop filter for shaping the output signal from the double phase detector and outputting the resultant signal as a controlled voltage signal to the plurality of voltage controlled delay devices of the complementary voltage controlled delay circuit.

3. An isophase multiphase clock signal generation circuit according to claim 1, wherein the double phase detector sequentially synchronizes the positive phase signals or the inverted phase signals of the second complementary clock signal with the complementary output signal from the complementary voltage controlled delay circuit.

4. An isophase multiphase clock signal generation circuit according to claim 2, wherein the double phase detector sequentially synchronizes the positive phase signals or the inverted phase signals of the second complementary clock signal with the complementary output signal from the complementaryvoltagecontrolleddelaycircuit.

5. An isophase multiphase clock signal generation circuit according to claim 1, wherein the double phase detector synchronizes the positive phase signals of the second complementary clock signal with the inverted phase signals of the complementary output signal from the complementary voltage controlled delay circuit, and synchronizes the inverted phase signals of the second complementary clock signal with the positive phase signals of the complementary output signal from the complementaryvoltagecontrolleddelaycircuit.

6. An isophase multiphase clock signal generation circuit according to claim 2, wherein the double phase detector synchronizes the positive phase signals of the second complementary clock signal with the inverted phase signals of the complementary output signal from the complementary voltage controlled delay circuit, and synchronizes the inverted phase signals of the second complementary clock signal with the positive phase signals of the complementary output signal from the complementaryvoltagecontrolleddelaycircuit.

7. An isophase multiphase clock signal generation circuit according to claim 1, wherein the double phase detector synchronizes rise edges of the positive phase signals of the second complementary clock signal with rise edges of the inverted phase signals of the complementary output signal from the complementary voltage controlled delay circuit, and synchronizes rise edges of the inverted phase signals of the second complementary clock signal with rise edges of the positive phase signals of the complementary output signal from the complementary voltage controlled delay circuit.

8. An isophase multiphase clock signal generation circuit according to claim 2, wherein the double phase detector synchronizes rise edges of the positive phase signals of the second complementary clock signal with rise edges of the inverted phase signals of the complementary output signal from the complementary voltage controlled delay circuit, and synchronizes rise edges of the inverted phase signals of the second complementary clock signal with rise edges of the positive phase signals of the complementary output signal from the complementary voltage controlled delay circuit.

9. An isophase multiphase clock signal generation circuit according to claim 1, wherein a duty ratio of the first complementary clock signal is within the range of 10% to 90%.

10. An isophase multiphase clock signal generation circuit according to claim 2, wherein a duty ratio of the first complementary clock signal is within the range of 10% to 90%.

11. An isophase multiphase clock signal generation circuit according to claim 1, further comprising a doubler circuit for converting a cycle period of the isophase multiphase clock signals.

12. An isophase multiphase clock signal generation circuit according to claim 2, further comprising a doubler circuit for converting a cycle period of the isophase multiphase clock signals.

13. A serial digital data receiving circuit, comprising:
an isophase multiphase clock signal generation circuit including:
a frequency division circuit for 1/2-frequency-dividing an input first complementary clock signal to generate a second complementary clock signal having a constant duty ratio, the frequency division circuit including control means for sequentially synchronizing positive phase signals or inverted phase signals of the second complementary clock signal;
a complementary voltage controlled delay circuit including a plurality of voltage controlled delay devices connected in series, wherein the complementary voltage controlled delay circuit receives the second complementary clock signal input thereto, generates isophase multiphase clock signals having a phase difference respectively in the plurality of voltage controlled delay devices, and generates a complementary output signal in the final-stage device of the plurality of voltage controlled delay devices;
a double phase detector for comparing the phase of the complementary output signal from the complementary voltage controlled delay circuit with the phase of the second complementary clock signal; and
a loop filter for shaping the output signal from the double phase detector and outputting the resultant signal as a controlled voltage signal to the plurality of voltage controlled delay devices of the complementary voltage controlled delay circuit; and a de-serializer for de-serializing input serial digital data based on the isophase multiphase clock signals.

14. A serial digital data receiving circuit according to claim 13, wherein the frequency division circuit includes control means for sequentially synchronizes rise edges of the first complementary clock signal with rise edges of positive phase signals or rise edges of inverted phase signals of the second complementary clock signal.

15. A serial digital data receiving circuit according to claim 13, wherein the double phase detector sequentially synchronizes the positive phase signals or the inverted phase signals of the second complementary clock signal with the complementary output signal from the complementary voltage controlled delay circuit.

16. A serial digital data receiving circuit according to claim 13, wherein the double phase detector synchronizes the positive phase signals of the second complementary clock signal with the inverted phase signals of the complementary output signal from the complementary voltage controlled delay circuit, and synchronizes the inverted phase signals of the second complementary clock signal with the positives phase of the complementary output signal from the complementary voltage controlled delay circuit.

17. A serial digital data receiving circuit according to claim 13, wherein the double phase detector synchronizes rise edges of the positive phase signals of the second complementary clock signal with rise edges of the inverted phase signals of the complementary output signal from the complementary voltage controlled delay circuit, and synchronizes rise edges of the inverted phase signals of the second complementary clock signal with rise edges of the positive phase signals of the complementary output signal from the complementary voltage controlled delay circuit.

18. A serial digital data receiving circuit according to claim 13, wherein a duty ratio of the first complementary clock signal is within the range of 10% to 90%.

19. A serial digital data receiving circuit according to claim 14, wherein a duty ratio of the first complementary clock signal is within the range of 10% to 90%.

20. A serial digital data receiving circuit according to claim 13, wherein further comprising a doubler circuit for converting a cycle period of the isophase multiphase clock signals.
